# EUROPEAN PATENT APPLICATION

(11) **EP 1 638 384 A1**
(43) Date of publication of application: **22.03.2006**
(21) Application number: 05445068.9
(22) Date of filing: 12.09.2005
(51) Int. Cl.: H05K 7/20, H05K 1/02

(54) **Circuit arrangement for cooling of surface mounted semi-conductors**

(30) Priority: 20.09.2004 SE 0402262
(71) Applicant: Danaher Motion Stockholm AB, 135 70 Stockholm (SE)
(72) Inventor: Nilson, thord Agne Gustaf, 135 54 Tyresö (SE); Ro, Ola, 192 55 Sollentuna (SE); Karlsson, Ulf Bengt Ingemar, 128 48 Bagarmossen (SE); Förborgen, Carl Erik Mikael, 135 36 Tyresö (SE); Berglund, Jan Anders, 176 70 Järfälla (SE); Röcklinger, Erik Hakan, 122 37 Enskede (SE)
(74) Representative: Estreen, Lars J.F.

(57) **Abstract**

A circuit arrangement comprises a circuit board (10), a semi-conductor (12) provided on a first side of the circuit board, and a heat sink (15) provided on a second side of the circuit board opposite to the first side and in heat transferring contact with the power semi-conductor. A heat conductive element (13) is provided in a hole (10a) in the circuit board, wherein the heat conductive element is positioned in heat transferring contact with both the semi-conductor and the heat sink for transfer of heat generated by the semi-conductor to the heat sink. A circuit arrangement is provided, wherein the provision of a low thermal resistance path through the circuit board by means of heat conductive elements provides a compact circuit arrangement well suited for assembly by means of an automated surface mounting process.

## Description

### FIELD OF INVENTION

This invention relates to a circuit arrangement for surface mounted semi-conductors. In particular, the invention concerns a circuit arrangement which comprises a circuit board carrying semi-conductors, heat conductive plugs, and a heat sink disposed in a heat transferring contact by a thermally conductive electrical insulator. The heat sink may be an integral part of the unit-supporting framework. The invention also relates to a method of assembling a circuit arrangement.

### BACKGROUND

Semi-conductors, such as power semi-conductors, generate heat from losses that have to be dissipated by heat sinks to carry away the loss energy. One common way to solve this is to use through-hole mounted components and press the semi-conductors to a heat sink. These semi-conductors are pressed, either by a pressure spring, or screwed to the heat sink most often with a thermally conductive electrical insulator inbetween. These solutions form a good thermal path/contact between the semi-conductors and the heat sink and thereby effective heat dissipation of the semi-conductor is achieved.

Rational and fully automated production is desirable for production of units including semi-conductors and it is therefore desirable to use surface mounted semi-conductors instead of the through hole mounted semi-conductors. One solution for applying surface mounted semi-conductors with high power losses on a circuit board is to introduce many via-holes through the circuit board in the neighbourhood of the mounted semi-conductor. The backside of the circuit board can then be pressed to the heat sink via a thermally conductive electrical insulation. The losses generated by the semi-conductor are then transported, mainly by via-holes, to the other side of the circuit board and then further on to the thermally conductive electrical insulation and the heat sink. This solution, however, has the drawback of limited heat transfer through the via-holes due to the limited cross-section metal area thereof. Also, this solution may result in rough surfaces, degrading the heat transfer capacity and thereby the final cooling efficiency.

US patent application US2002/0109220 describes surface mounted power semi-conductors in the form of transistors that are cooled by positioning of a heat sink in the form of a mounting plate between the power semi-conductor and solder pad on the circuit board. However, the above-mentioned surface mounted transistor and heat sink have the following problem: When the heat sink is fixed directly on the circuit board the cooling efficiency is limited due to mechanical layout considerations and therefore the power semi-conductors current capability has to be de-rated due to the limited cooling capability.

US patent 5,459,640 describes another way where a breakaway portion of a circuit board is located under a power module. After soldering of the power module this breakaway portion is removed and the power module is put in direct contact with the heat sink. However, the above mentioned electrical power module mounting apparatus and method have the following problems. The breakaway portion must be removed which is complicated to make in an automatic process. Also, no electrical insulation is provided between the power module and mounting structure, the heatsink itself mechanically goes through the printed circuit board and is clamped to the cooling surface of the power module, so the power module itself must therefore provide the electrical insulation. This is a severe drawback if discrete SMD power-semiconductors are to be used because they are non-insulated in their nature. For example To263 has its cooling surface acting as one of the three electrical connections that need to be connected to the printed circuit board and at the same time, in most cases, also must be electrically isolated from heatsink potential. The described method is also difficult to fully automate due to the breakaway portion. In addition, the method describes through-hole mounted power modules.

### SUMMARY OF THE INVENTION

An object of the invention is to provide a compact circuit arrangement with a circuit board, a semi-conductor, and a heat sink, which includes a low thermal resistive path from a heat dissipating semi-conductor provided on a first side of a circuit board to a heat sink provided on a second side of the circuit board. A further object of the invention is to provide a mechanical distance between the circuit board and the heat conductive electrical insulator/mounting structure.

A further object of the invention is to provide a method of assembling such a circuit arrangement that is fully automated and standard for surface mounted circuit board manufacturing.

The invention is based on the realisation that a heat conductive element can be provided in a large through hole in the circuit board, which provide a low thermal resistance path for dissipated heat and which nevertheless allows an automated mounting process. This element will also act as a heat spreader between the semi-conductor and the heat sink.

According to a first aspect of the invention there is provided a circuit arrangement as defined in appended claim 1. According to a second aspect of the invention there is provided a method of assembling a circuit arrangement as defined in appended claim 11.

Further preferred embodiments are defined by the dependent claims.

Thus there is provided a circuit arrangement, wherein the provision of a low thermal resistance path through the circuit board by means of heat conductive elements gives a compact arrangement well suited for assembly by means of an automated surface mounting process.

Further objects and advantages of the invention will appear from the following specification in which preferred embodiments of the invention are described in detail with reference to the accompanying drawings.

### BRIEF DESCRIPTION OF DRAWINGS

The invention is now described, by way of example, with reference to the accompanying drawings, in which:
Fig. 1 shows a top view of an assembled circuit board carrying semi-conductors according to the invention where heat conductive plugs are inserted from above;
Fig. 2 shows in larger scale a section of the assembled circuit board of Fig. 1;
Fig. 3 shows in larger scale a section of the assembled circuit board of Fig. 1;
Fig. 4 shows in larger scale a section of the assembled circuit board of Fig. 2;
Fig. 5 shows a top view of an assembled circuit board carrying semi-conductors according to the invention where heat conductive plugs are inserted from below;
Fig. 6 shows in larger scale a section of the assembled circuit board of Fig. 5;
Fig. 7 shows in larger scale a section of the assembled circuit board of Fig. 6;
Fig. 8 shows an assembled unit including a clamping bar;
Fig. 9 shows in a larger scale a section of Fig. 8;
Fig. 10 shows an alternative embodiment wherein several heat conductive plugs are replaced by one single heat conductive bar;
Fig. 11 shows a section of the embodiment of Fig. 10; and
Fig. 12 shows a drive unit and a motor for use with a circuit arrangement according to the invention.

### DETAILED DESCRIPTION OF THE INVENTION

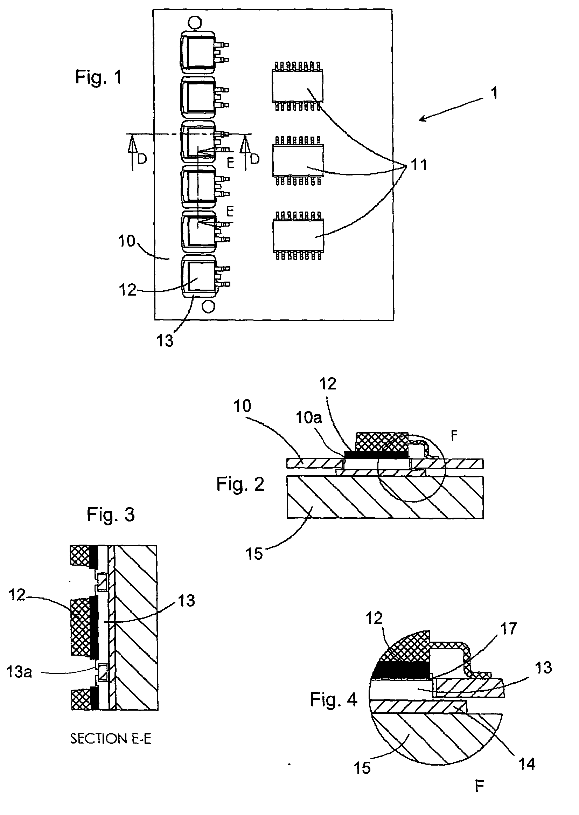

In the following a detailed description of preferred embodiments of the present invention will be given. The circuit arrangement illustrated in Figs. 1-4 and generally designated 1 comprises a circuit board 10, which carries a number of components 11, such as logic components connected to copper foils on the circuit board. The circuit board can be of any suitable kind, such as a flame retardant board known as FR4 printed circuit board. This board has excellent flame retardant properties but poor heat conductive properties, making a special cooling arrangement for mounted components more important.

A number of power semi-conductors 12, such as in the form of D2 packages, also known as To263 packages, having a cooling surface of metal and two connecting pins, wherein the cooling surface functions as a third electrical connector, are mounted on top of a respective of a corresponding number of heat conductive plugs 13, which are provided in a respective through hole in the circuit board 10. The plugs 13 consist of a material with good heat conducting properties, such as copper or aluminium or alloys thereof. A small rim or flange 13a is provided on the plugs, see Fig. 3, so as to locate the plug in the hole. By having the underside of the flange essentially at the same level as the surface in contact with the power semi-conductor, the arrangement is insensitive to thickness variations of the circuit board as long as the plug extends to the underside of the circuit board. As illustrated in Figs. 1-4, by locating the heat conductive plugs 13 in thermal contact with the power semi-conductors 12, and in the preferred embodiment directly below the corresponding power semi-conductor 12, the heat transfer is maximized. Most preferably, the entire cooling surfaces of the semi-conductors are in thermal contact with the heat conductive plugs.

The plugs 13 in the first embodiment are shaped for insertion from the top of the circuit board 10 and into a corresponding through hole. Figs. 2 and 3 show enlarged cross-sections where the plug 13 has been inserted from the top. By mounting the plugs on the same side as the other surface mounted components one side surface mounting is allowed.

The heat conductive plugs 13 can be of various shapes, such as elliptical or rectangular. The part extending through the circuit board may have a different shape from the rest of the plugs to effect a heat spreading function by increasing the cross-sectional area.

A heat conductive electrical insulator 14 is provided below each plug 13 and between the plugs and a heat sink 15, which may be an integral part of a unit-supporting framework. The heat conductive electrical insulator 14 and the heat sink 15 are shown in more detail in Fig. 4. There can be one single insulator for several plugs 13. It will also be appreciated that the insulator 14 can be omitted when no electrical insulation between the semi-conductor 12 and the heat sink 15 is required.

A method of assembling the above described circuit arrangement will now be described.

First, solder paste is applied onto the circuit board 10 by means of some suitable method, such as screening or dispensing. Then, the heat conductive plugs 13 are inserted into a respective hole 10a in the circuit board 10 from above. This insertion can be effected manually or by means of an automated process.

The power semi-conductors 12 are surface mounted onto the circuit board 10 and the heat conductive plugs 13 by soldering or gluing with a thermally and electrically conductive glue so as to obtain an efficient heat transfer from the power semi-conductor 12 to the heat conductive plug 13.

The heat conductive plugs 13 are preferably soldered to the circuit board 10 at the same time as soldering of the power semi-conductors 12 and they can thereby act as electrical connection to the circuit board. In order to have a fully automated circuit board assembly where the heat conductive plugs 13 are mounted in the same mounting machine as the power semi-conductors 12, solder pre-forms 17, i.e., a thin metal plate of solder, can be placed on top of the heat conductive plugs as shown in Fig. 4. This is done in order to facilitate soldering of the power semi-conductors to the heat conductive plugs when soldering the assembled circuit board. On the other solder pads on the circuit board 10 the solder material is applied by the normal method such as screening of solder paste on the solder pads.

The power semi-conductors 12 and the heat conductive plugs 13 are soldered to the pads on the circuit board 10. The mounting of the plugs 13 as well as the mounting of the semi-conductors 12 can be carried out using established, automated surface mount techniques, such as using pick & place machines. Alternatively, the heat conductive plugs 13 may be secured to the circuit board 10 by thermally and/or electrically conductive glue or by means of press fitting.

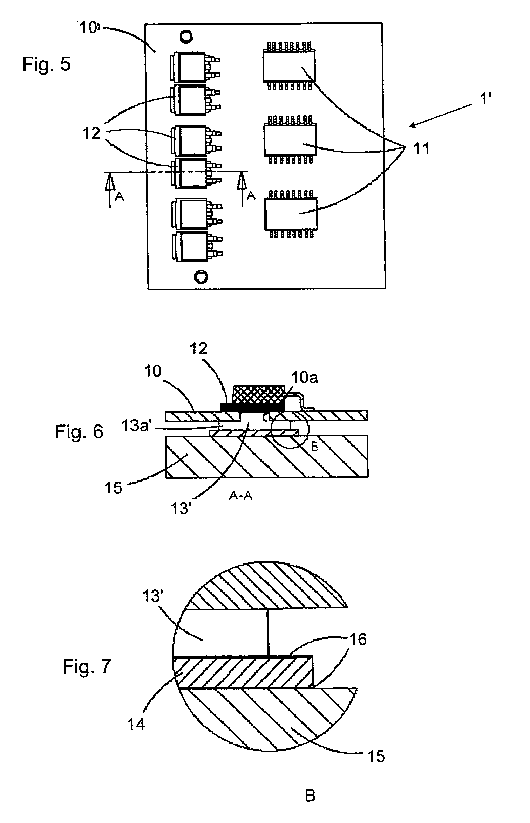

In Figs. 5-7 an alternative embodiment of a circuit arrangement 1' according to the invention is shown. In this embodiment, heat conductive plugs 13' are arranged to be mounted from the backside of a circuit board 10. As shown in Fig. 6, a rim or flange 13a' extends on the heat conductive plugs which abuts the underside of the circuit board. An in the first embodiment, surface mounted power semi-conductors 12 are mounted on top of the heat conducting plugs 13'. The heat conductive plugs are in heat transfer contact with a heat conductive electrical insulator 14, which is mounted on top of a heat sink 15.

It is seen in Fig. 6 that the upper surface of the plug 13' is flush with the upper surface of the circuit board 10. This can be obtained by the mounting process and the above mentioned press fit. This provides an even surface facilitating the surface mounting process of the semi-conductors.

Fig. 7 shows in enlargement a portion of Fig. 6 which is defined by the circle "B". Here thermal grease 16 has been applied on both sides of the insulator 14 for decreasing the thermal resistance between the heat conductive plug 13' and the heat sink 15.

A method of assembling the second embodiment of circuit arrangement described with reference to Figs. 5-7 will now be described.

First, the heat conductive plugs 13' are inserted into a respective hole 10a in the circuit board 10 from below. This insertion can be effected manually or by means of an automated process. The plugs are preferably retained in the holes by means of press fit. Then, solder paste is applied onto the circuit board 10 and the upper surface of the plugs 13' by means of some suitable method, such as screening or dispensing. Following this step, the components 11 and the semi-conductors 12 are applied and then soldered or glued to the circuit board 10.

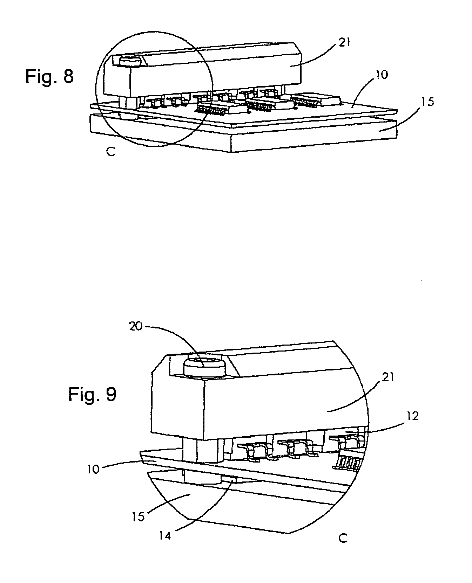

Figs. 8 and 9 show an arrangement by means of which a good thermal path for the dissipation of the power losses in the power semi-conductors 12 is obtained. The power semi-conductors 12, the circuit board 10 and the heat conductive electrical insulator 14 are clamped together to the heat sink 15 by means of a clamp bar 21 and a number of screw joints. Each of these screw joints comprises a screw 20 that extends through or beside the circuit board 10 as well through or beside the heat conductive electrical insulator 14. The screw is secured to the heat sink 15. The heat conductive plugs 13 are located between the power semi conductors 12 and the heat conductive electrical insulator 14 so that the clamping force on the power semi-conductors is transferred to the heat conductive electrical insulator 14 thereby accomplishing a contact pressure between the power semi-conductors 12, the heat conductive plugs 13, the heat conductive electrical insulator 14 and the heat sink 15.

Accordingly, the screw joints for clamping shown in Figs. 8 and 9 may be of a completely different design or be omitted entirely. For instance, instead of having the screws 20 extend coaxially through the circuit board 10, there may be used one or several screws which are located in the middle of the circuit board 10 or in a pattern where the clamping forces of the screws 20 are evenly distributed to the heat conductive plugs 13 and to the heat conductive electrical insulation 14.

Another embodiment of the invention (not shown) includes a clamping means in the form of one or more spring elements acting on the power semi-conductors 12 in one or several locations to transfer the clamping force to the heat conductive plugs 13. The spring or springs may be coupled to the mounting structure 15 via anchor bolts extending through the circuit board 10 and the heat conductive electrical insulator or via a drive unit framework surrounding the circuit board 10.

Since the heat conductive plugs 13 have a relatively large contact area against the heat conductive electrical insulator 14, the contact pressure between the heat conductive electrical insulator 14 and the heat sink 15 is distributed across a relatively large area. This means that the conditions are good for obtaining an efficient heat transport from the power semi-conductors 12, via the heat conductive plugs 13, via the heat conductive electrical insulator 14 to the heat sink 15. To further facilitate this heat transport, thermal grease 16, shown in Fig. 7, may be applied between the heat conductive electrical insulator 14 and the mounting structure and/or between the heat conductive plugs 13 and the heat conductive electrical insulator 14.

Alternatively the heat conductive plugs 13 are made pre-equipped with a thermally conductive electrical insulation layer attached directly on the surface towards the heat sink 15. The separate heat conductive electrical insulator 14 can then be omitted.

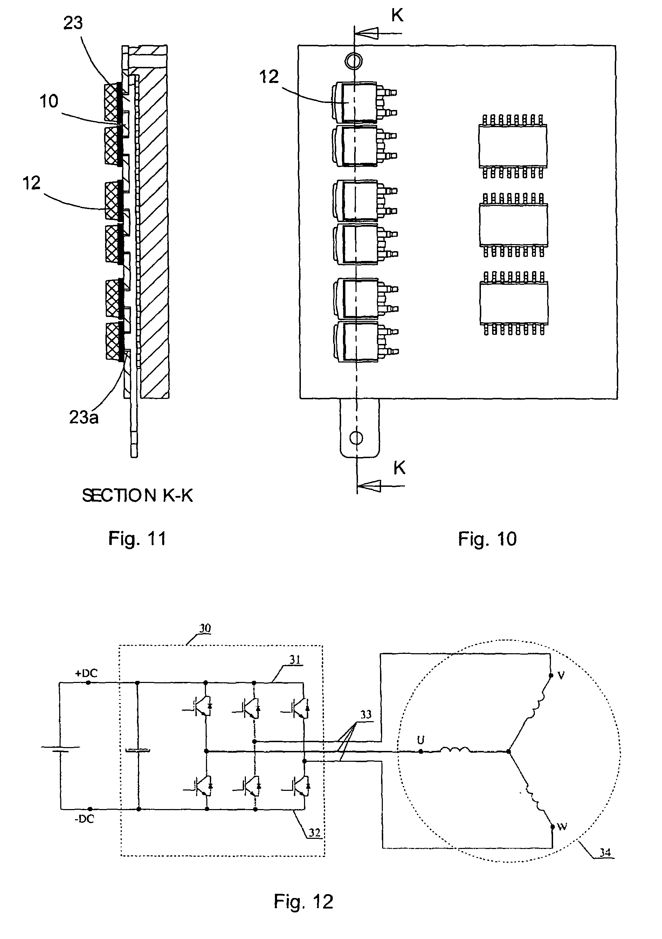

One heat conductive plug has been shown for each semi-conductor. In an alternative embodiment shown in Figs. 10 and 11, one common heat conductive bar 23 is used for transferring heat from several semi-conductors 12. The bar is provided with a plurality of protrusions 23a having a shape to be inserted from below the printed circuit board 10. This solution facilitates assembly of the circuit arrangement in that several plugs are replaced by only one bar and is particularly suitable when the contacting surfaces of the semi-conductors are at the same voltage level. There can be more than one such bar.

By making the heat conductive plugs 13 of an electrical conductive material, like copper or any other suitable metal, they can also be used as electrical interconnections. Fig. 12 shows a sketch of an application where the invention is used in an electrical drive unit 30 controlling a motor 34. The plugs may be used for connecting the DC bus plus voltage 31, the DC bus minus voltage 32 or the phase output voltages 33 to groups of the power semi-conductors 12. This is especially an advantage when power semi-conductors 12 are operating in parallel to obtain high current capability. With this configuration, the bar 23 described with reference to Figs. 8-10 can be used to an advantage.

The invention can generally be applied for applications where power semi-conductors are used.

Among others, the invention can be applied to:
1) Electrical drive unit for DC- and/or AC motor control.
2) Power supplies both AC to DC, DC to DC, DC to AC, and AC to AC.

Preferred embodiments of a circuit arrangement according to the invention and methods of assembling it have been described. The person skilled in the art realises that these could be varied within the scope of the appended claims.

In the described embodiments of the invention the circuit board carries a number of logic components, but may in an alternative embodiment be formed as a pure power semi-conductor board. Also, other heat generating components than the described semi-conductors 12 could be used with the inventive circuit arrangement, such as shunt resistors etc.

The inventive method is particularly suitable for surface mounting. It will be appreciated that it can be used with other mounting method as well, such as manual soldering of components.

## Claims

1. A circuit arrangement, comprising:
a circuit board (10),
a semi-conductor (12) provided on a first side of the circuit board,
a heat sink (15) provided on a second side of the circuit board opposite to the first side and in heat transferring contact with the power semi-conductor,
**characterized by**
a heat conductive element (13; 13'; 23) provided in a through hole (10a) in the circuit board, wherein the heat conductive element is positioned in heat transferring contact with both the semi-conductor and the heat sink for transfer of heat generated by the semi-conductor to the heat sink,
wherein the heat conductive element (13; 13'; 23) comprises a flange (13a; 13a') locating the heat conductive element in the hole (10a), and
wherein the flange (13a) extends on the first side of the circuit board (10).

2. The circuit arrangement according to claim 1,
wherein the upper surface of the heat conductive element (13') is flush with the upper surface of the circuit board (10).

3. The circuit arrangement according to claim 1 or 2, comprising a heat conductive electrical insulator (14) between the heat conductive element (13; 13'; 23) and the heat sink (15).

4. The circuit arrangement according to any of claims 1-3, comprising a plurality of semi-conductor elements (12) and a heat conductive element (23) in heat transferring contact with the plurality of semi-conductors.

5. The circuit arrangement according to any of claims 1-4, wherein the semi-conductor (12) is soldered by means of solder or glued by means of a thermally conductive glue to the heat-conductive element (13; 13'; 23).

6. The circuit arrangement according to any of claims 1-5, wherein the heat conductive element (13; 13'; 23) is used as electrical connection to the semi-conductor (12).

7. The circuit arrangement according to any of claims 1-6, comprising a clamp bar (21) on the first side of the circuit board (10) and being connected to the heat sink (15), preferably by means of a screw joint, so that a clamping force is applied on the semi-conductor (12), the heat conductive element (13; 13'; 23) and the heat sink (15).

8. The circuit arrangement according to any of claims 1-7, wherein the heat conductive element (13; 13'; 23) is made of a material chosen from the group comprising copper and aluminium and alloys thereof.

9. The circuit arrangement according to any of claims 1-8, wherein the semi-conductor (12) is in the form of a To263 package.

10. The circuit arrangement according to any of claims 1-9, wherein the circuit board (10) is a flame retardant board, such as an FR4 board.

11. A method of assembling a circuit arrangement with a circuit board (10), a semi-conductor (12), and a heat sink (15), the method comprising the following steps:
- providing a through hole (10a) in the circuit board;
- providing a heat conductive element (13; 13'; 23) in the through hole;
- providing the semi-conductor in heat transferring contact with the heat conductive element on a first side of the circuit board;
- electrically connecting the semi-conductor to the circuit board; and
- applying the heat sink (15) in heat conducting contact with the heat conductive element on a second side of the circuit board;
- wherein the step of providing a heat conductive element (13; 13'; 23) comprising positioning the heat conductive element by means of a flange (13a; 13a'); and
- wherein the heat conductive element (13) is provided in the hole (10a) from the first side of the circuit board (10).

12. The method according to claim 11, wherein the step of providing the semi-conductor comprises placing a solder pre-form (17) onto the heat conductive element (13).

13. The method according to claim 11 or 12, wherein the step of providing a heat conductive element (13; 13'; 23) comprises positioning the heat conductive element by means of press fit.

14. The method according to any of claims 11-13,
wherein the step of connecting the semi-conductor to the circuit board comprises soldering by means of solder or gluing by means of electrically conductive glue.

15. The method according to any of claims 11-14, comprising the additional step of applying solder material by means of screening or deposition.

16. The method according to any of claims 11-15, comprising the additional step of applying a heat conductive electrical insulator (14) between the heat conductive element (13; 13'; 23) and the heat sink (15).
